# EUROPEAN PATENT SPECIFICATION

(11) **EP 4 309 836 B1**
(45) Date of publication and mention of the grant of the patent: **22.04.2026**
(21) Application number: 22771383.1
(22) Date of filing: 14.03.2022
(51) Int. Cl.: C23C 14/06, C23C 14/00, C23C 14/32, C04B 41/00, C04B 41/52, C04B 41/89

(54) **SURFACE-COATED CUTTING TOOL**
OBERFLÄCHENBESCHICHTETES SCHNEIDWERKZEUG
OUTIL DE COUPE DOTÉ D'UN REVÊTEMENT DE SURFACE

(30) Priority: 17.03.2021 JP 2021043485
(43) Date of publication of application: 24.01.2024
(73) Proprietor: Mitsubishi Materials Corporation, Tokyo 100-8117 (JP)
(72) Inventor: DOBASHI, Masataka, Tokyo 100-8117 (JP)
(74) Representative: Gille Hrabal Partnerschaftsgesellschaft mbB Patentanwälte
(86) International application number: PCT/JP2022/011322
(87) International publication number: WO 2022/196637

(56) References cited:
- JP-A- 2009 255 282
- JP-A- 2009 255 282
- JP-A- 2015 110 258
- JP-A- 2015 110 258
- JP-A- 2016 107 396
- JP-A- 2016 107 396
- JP-A- 2017 080 879
- JP-A- 2017 080 879
- JP-A- 2020 151 774

## Description

### Technical Field

The present invention relates to a surface-coated cutting tool (hereinafter, referred to as coated tool). This application claims the priority benefit of Japanese Patent Application No. 2021-043485 filed on March 17, 2021.

### Background Art

Coated tools have been used that include substrates made of cubic boron nitride (hereinafter referred to as cBN) sintered compacts and coating layers formed on the surfaces of the substrates, in order to improve the service lives of cutting tools. Such coated tools have improved wear resistance. In order to further improve the cutting performance of coated tools, various proposals have been made regarding the compositions and structures of the coating layers

For example, PTL 1 discloses a coated tool that includes a substrate composed of cBN sintered compact and a coating layer, and the surface of the substrate has a plurality of convex portions due to the cBN grains and a plurality of concave portions due to a bonding material, where
the coating layer has a composition represented by MₓL_{y} (0 <x ≤ 1.2 and y = 1), where M is at least one element selected from the groups consisting of groups 4 to 6 elements, aluminum, and silicon in the periodic table, and L is at least one element selected from the group consisting of boron, carbon, nitrogen, and oxygen;
the substrate has a surface roughness R_{sub} of 0.1 to 0.4 µm;
the coating layer has a topmost surface having a roughness R_{surf} of 0 to 0.15 µm, and having a roughness R_{asurf} of 0 to 0.1 µm;
R_{sub} is larger than R_{surf}, and the coating layer has a thickness of 0.2 to 10 µm. The coated tool is durable even in high-load and high-rate cutting operations.

PTL2 relates to a surface coated cutting tool having a hard coating layer provided on a surface of a tool body made of a cubic boron nitride sintered body, wherein the hard coating layer includes at least a lower layer made of a complex nitride layer of Al, Ti and Si formed on the surface of the tool body and an upper layer made of a complex nitride layer of Al, Cr, Si and Cu formed on the lower layer, an intermediate layer optionally being interposed between the lower layer and the upper layer.

### Citation List

### Patent Literature

[PTL 1] Japanese Patent No. 5879664
[PTL 2] JP 2017 080879 A

### Summary of Invention

### Technical Problem

An object of the present invention, which was made in view of the aforementioned circumstances and proposal, is to provide a coated tool that exhibits high wear resistance and chipping resistance even in high-load cutting.

### Solution to Problem

A surface-coated cutting tool in accordance with embodiments of the present invention includes a substrate and a coating layer provided on the substrate;
the substrate including a sintered compact containing cubic boron nitride grains in an amount of 40 vol% or more and 70 vol% or less, the substrate having a surface roughness R of 0.1 µm or more and 1.5 µm or less, the cubic born nitride grains having a mean grain size of 2.5 µm or more and 6.0 µm or less;
the coating layer having an average thickness of 1.0 µm or more and 5.0 µm or less, the coating layer including an A layer, a B layer, and a C layer from the surface of the substrate toward the surface of the tool;
the A layer having an average composition represented by the formula: (Al₁₋ₓTiₓ)N (where 0.35 ≤ x ≤ 0.60) and an average thickness t_{A} of 0.1 µm or more and 1.0 µm or less;
the B layer having an average composition represented by the formula: (Al_{1-y-z}Ti_{y}Si_{z})N (where 0.35 ≤ y ≤ 0.60 and 0.01 ≤ z ≤ 0.10) and an average thickness t_{B} of 0.2 µm or more and 2.0 µm or less;
the C layer having an average composition represented by the formula (Al_{1-a-b-c}CrₐSi_{b}Cu_{c})N (where 0.150 ≤ a ≤ 0.400, 0.050 ≤ b ≤ 0.200 and 0.005 ≤ c ≤ 0.050) and an average thickness t_{C} of 0.1 µm or more and 2.0 µm or less; and
the ratio t_{B}/t_{A} being 2.0 or more and 6.0 or less, and R ≤ t_{C}.

The surface-coated cutting tool of the above embodiment may satisfy the following requirement (1):

### (1) A TiN layer may be disposed on the C layer.

### Advantageous Effects of Invention

The surface-coated cutting tool exhibits high wear resistance and chipping resistance even in high-load cutting.

### Brief Description of Drawing

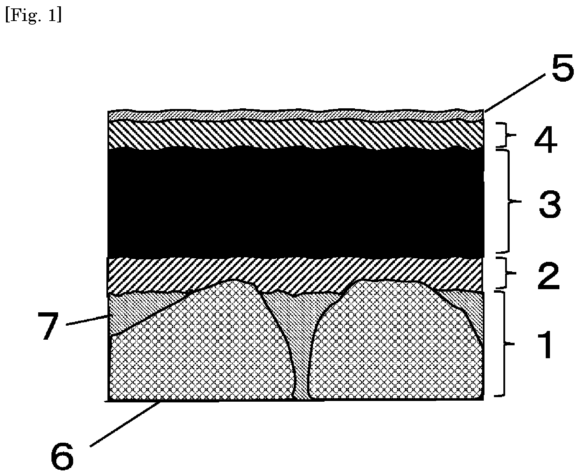

Fig. 1 is a schematic longitudinal sectional view of a surface-coated cutting tool in accordance with an embodiment of the present invention. Description of Embodiments

The present inventor has reviewed the coated tools described in PTL 1, and confirmed that mere control of the surface roughness of the substrate and the coating layer does not lead to sufficiently high chipping resistance.

Based on such a finding, the inventor has made an intensive study. As a result, the inventor has found the following knew knowledge: A coated tool exhibiting high wear resistance and chipping resistance even in high-load cutting can be produced by overlaying a composite nitride layer of Al and Ti (hereinafter referred to as AlTiN layer) and a composite nitride layer of Al, Ti and Si (hereinafter referred to as AlTiSiN layer) on a cBN sintered compact; providing a composite nitride layer of Al, Cr, Si and Cu (hereinafter referred to as AlCrSiCuN layer); controlling the surface roughness of the substrate; and controlling the thickness of the AlCrSiCuN layer depending on the surface roughness of the substrate,.

The high-load cutting refers to a cutting process that applies a greater load to the cutting tool than in normal cutting.

The coated tool in accordance with embodiments of the present invention will now be described in detail.

Throughout the specification and the claims, a numerical range expressed as "L to M" (L and M are both numerical values), the range includes the upper limit (M) and the lower limit (L), and a unit stated only for the upper limit (M) is also applicable to the unit for the lower limit (L).

Fig. 1 schematically illustrates a longitudinal section (definition will be described below) of the coated tool of this embodiment. The drawing shows that the coated tool of this embodiment has a coating layer including, in order, a first AlTiN layer (2) as an A layer, a second AlTiSiN layer (3) as a B layer, and a third AlCrSiCuN layer (4) as a C layer on the surface of a substrate composed of a cBN sintered compact (1). The TiN layer (5) is an optional layer, as described below, and thus may be omitted.

These components will now be described in sequence.

### 1. Cubic boron nitride (cBN) sintered compact

The cBN sintered compact constituting the substrate includes a hard layer composed of cBN grains (6) and a binder phase (7), as shown in Fig. 1.

### (1) cBN grains

The mean grain size of cBN grains and the content of the cBN grains in a cBN sintered compact will now be described.

### (1-1) Mean grain size

The mean grain size of the cBN grains used in this embodiment is in the range of 2.5 µm or more and 6.0 µm or less for the following reasons:

A sintered compact including cBN grains basically has enhanced chipping resistance. In addition, a mean grain size of 2.5 to 6.0 µm reliably reduces chipping and defects originating from irregularities of the edge caused by cBN grains falling off the surface of the substrate of a coated tool in use. Such a mean grain size can also effectively prevent the propagation of cracking from the interface between the cBN grains and binder phase or propagation of cracking originated from cracking of the cBN grains caused by stress applied to the cutting edge during cutting, resulting in superior chipping resistance. The mean grain size of the cBN grains preferably is in a range of 2.5 µm or more to 4.0 µm or less.

The mean size of the cBN grains can be determined as follows:
A longitudinal section of the cBN sintered compact (a cross-section perpendicular to the plane, ignoring minute irregularities on the surface of the cBN sintered compact), is mirror-finished, and the mirror-finished surface is observed by scanning electron microscopy (SEM) to give a secondary electron image. The portions of cBN grains in the resulting image are extracted by image processing, and the mean grain diameter is calculated from the maximum length of each particle determined by image analysis, as described below.

Portions of the cBN grains in the image are extracted by image processing as follows: The image is displayed in 256 monochromatic shades with 0 being black and 255 being white, in order to clearly discriminate the cBN grains from the bonded phase; and the image is binarized with a threshold calculated by (B-A)/2+A where A is the pixel value in the cBN grain regions and B is the pixel value in the binder phase region.

It is preferable to determine pixel values of at least three different cBN grains within the same image area and to define the average of the three pixel values as the peak pixel value of the cBN grain. The region for determining the pixel values of each cBN grain has dimensions of, for example, about 0.5 µm by 0.5 µm. It is preferable to determine pixel values of at least three different binder phases within the same image area and to define the average of the three pixel values as the peak value of the binder phase. The region for determining the pixel values of each binder phase has dimensions of about 0.2 µm by 0.2 µm to 0.5 µm by 0.5 µm.

The binarization process is followed by a treatment involving separation of cBN grains from each other, for example, a watershed image treatment.

The areas corresponding to cBN grains (black areas) in the image after the binarization process are subjected to grain analysis. The Feret's diameters in the vertical and horizontal directions of each cBN grain is determined by the grain analysis and the larger one of the two Feret's diameters is defined as the diameter of each grain.

Under the assumption that each grain is an ideal sphere with such a diameter, the volume of each grain is calculated. The cumulative volume of all the grains is then calculated. Based on the cumulative volume, a graph is plotted with the vertical axis as volume percentage (%) and the horizontal axis as diameter (µm). The diameter at 50% volume fraction is defined as the average diameter of cBN grains, and this operation is performed for three observation areas, and the average value is defined as the average diameter (µm) of the cBN grains.

Prior to the grain analysis, the length per pixel (µm) is preliminarily determined by SEM with a known standard scale. The observation area for image processing preferably contains at least 30 cBN grains. For example, the observation area is about 15 µm by 15 µm for an average size of about 3 µm of the cBN grains.

### (1-2) Content

The content (volume, vol%) of the cBN grains in the cBN sintered compact is 40 vol% or more and 70 vol% or less, for the following reasons.

A content less than 40 vol% leads to a reduced number of cBN grains as hard material in the cBN sintered compact, resulting in low defect resistance. A content exceeding 70 vol% leads to formation of voids, which may cause cracking, in the cBN sintered compact, resulting in low defect resistance. The preferred content of BN grains is 45 vol% or more and 65 vol% or less.

The content of cBN grains in the cBN sintered compact can be determined as follows: The longitudinal section of a cBN sintered compact is observed by SEM; the portions of cBN grains in the secondary electron image is extracted; and then the areas occupied by the cBN grains are calculated by image analysis. The calculation is performed in at least three observation regions, and all the areas are averaged to give a content (vol%) of the cBN grains. An observation region preferably contains at least 30 cBN grains. For example, a field of view of 15 µm by 15 µm is desirable for cBN grains having an average diameter of about 3 µm.

### (2) Binder phase

The binder phase of the embodiment may be composed of conventionally known grains, i.e., grains containing at least one compound selected from the group consisting of nitride, carbide, carbonitride, and boride of titanium and nitride and oxide of aluminum.

### (3) Surface roughness

The surface roughness R of the cBN sintered compact is µm or more and 1.5 µm or less for the following reasons: A surface roughness R less than 0.1 µm leads to insufficient adhesion to the A layer. A surface roughness R exceeding 1.5 µm leads to ready detachment of cBN grains at the interface between the substrate and the A layer during cutting and ready occurrence of chipping. In addition, the surface roughness of the coating layer will exceed 1.5 µm, which easily causes chipping and abnormal damage and forms rough surfaces of work members after machining. The roughness R is measured by SEM and will be defined below (see Item 2.(6)).

### 2. Coating layer

The coating layer includes an A layer being an AlTiN layer, a B layer being an AlTiSiN layer, and a C layer containing both an AlCrSiCuN layer and a TiN layer. The average thickness (average thickness of the sum of the A and B and C layers) t_{T} is 1.0 µm or more and 5.0 µm or less.

An average thickness t_{T} less than 1.0 µm leads to insufficient wear resistance of the coating layer. An average thickness exceeding 5.0 µm leads to increased strain in the coating layer, which may readily cause self-destruction of the coating layer.

The A layer being the AlTiN layer, the B layer being the AlTiSiN layer, and the C layer containing both the AlCrSiCuN layer and the TiN layer will be described in sequence.

### (1) A layer or AlTiN layer

The AlTiN layer (A layer) has an average composition represented by the formula: (Al₁₋ₓTiₓ)N, where x ranges from 0.35 to 0.60. At x less than 0.35, the crystal grain distortion of the A layer increases, resulting in tendency of self-destruction of the A layer. At x greater than 0.60, the hardness and oxidation resistance of the A layer decreases. Preferred x is within a range of 0.40 to 0.55.

Although the A layer is produced such that the ratio of (Al₁₋ₓTiₓ) to N is 1:1 in accordance with an example process described below, it may be inevitable or unintentional that the ratio is not 1:1 in some cases. This is also true for the other nitrides (composite nitrides and TiN constituting the B and C layers), which will be discussed below.

The A layer has an average thickness in the range of 0.1 µm to 1.0 µm. An average thickness t_{A} less than 0.1 µm causes the A layer not to work sufficiently as an adhesion layer with the substrate and the coating layer to detach under a high load applied to the cutting edge. A thickness exceeding 1.0 µm causes the strain in the A layer to increase and the A layer to self-destruct. The average thickness t_{A} of the A layer should preferably range from 0.2 µm to 0.7 µm.

### (2) B layer or AlTiSiN layer

The AlTiSiN layer (B layer) has an average composition represented by the formula: (Al_{1-y-z}Ti_{y}Si_{z})N, where y ranges from 0.35 to 0.60 and z ranges from 0.01 to 0.10 for the following reasons:

At y of less than 0.35, the crystal grain distortion of the B layer increases and the B layer readily self-destruct, while at y of greater than 0.60, the hardness of the B layer decreases and oxidation resistance also decreases. In preferred embodiments, y ranges from 0.40 to 0.55. At z of less than 0.01, the B layer does not have sufficient wear resistance, while at z of greater than 0.10, the crystal lattice distortion of the B layer increases and the B layer does not have sufficient chipping resistance. In preferred embodiments, z ranges from 0.03 to 0.07.

The B layer has an average thickness t_{B} in the range of 0.2 µm to 2.0 µm for the following reasons: At an average thickness t_{B} of less than 0.2 µm, the B layer does not work well as a wear-resistant layer, while at an average thickness exceeding 2.0 µm, the strain in the B layer increases and the B layer readily self-destruct. In preferred embodiments, the average thickness t_{B} of the B layer ranges from 0.5 µm to 1.5 µm.

The ratio t_{B}/t_{A} is within a range of 2.0 to 6.0, between the average thickness t_{A} of the A layer and the average thickness t_{B} of the B layer. The reason for this is that if it is less than 2.0, a small ratio of the B layer to the total coating layer leads to insufficient wear resistance due to the low B content, while if it exceeds 6.0, peeling of the coating layer is likely to occur under a high load to the cutting edge (in the case of high-load cutting).

### (3) C layer or AlCrSiCuN layer

Each component in the AlCrSiCuN layer (C layer) has the following function.

The Al component improves high-temperature hardness. The Cr component improves high-temperature toughness and high-temperature strength. Combination of Al and Cr improves high-temperature oxidation resistance. The Si component improves heat plastic deformation resistance. The Cu component improves wear resistance by refining crystal grains.

The AlCrSiCuN layer (C layer) has an average composition represented by the formula: (Al_{1-a-b-c}CrₐSi_{b}Cu_{c})N, where a ranges from 0.150 to 0.400, b ranges from 0.050 to 0.200, and c ranges from 0.005 to 0.050 for the following reasons:

At a of less than 0.150, the C-layer has insufficient high-temperature toughness and high-temperature strength and thus cannot suppress the occurrence of cracks that cause chipping and defects. At a of greater than 0.400, the wear resistance of the C-layer decreases due to a relative decrease in Al content. In preferred embodiments, a is within a range of 0.150 to 0.300.

At b of less than 0.050, the C layer cannot have a sufficient improvement in wear resistance due to an improvement in thermoplastic deformation resistance. At b exceeding 0.200, the wear resistance of the C layer decreases. In preferred embodiments, b ranges from 0.070 to 0.150.

At c of less than 0.005, wear resistance will not improve. At c of greater than 0.050, particles are readily generated during deposition of the C layer and the crack resistance of the C layer will decrease. In preferred embodiments, c ranges from 0.010 to 0.040.

The C layer has an average thickness t_{C} in the range of 0.1 µm to 2.0 µm. An average thickness t_{C} of less than 0.1 µm causes the C layer not to work well as a chipping-resistant layer, while an average thickness of more than 2.0 µm causes the strain in the C layer to increase and the C layer to self-destruct. In preferred embodiments, the average thickness t_{C} of the C layer should range from 0.5 µm to 1.5 µm.

A relation R ≤ t_{C} holds between t_{C} and R. Within the range where this relation is valid, the C layer can buffer (absorb) propagation of cracking that occurs during high-load cutting, and the coated tool has improved chipping resistance. On the contrary, within the range where this relation is not valid, cracks propagate to the substrate during high-load cutting, resulting in chipping due to the loss of entire cBN grains.

### (4) TiN layer

The C layer may be overlaid by a TiN layer.

The deposited TiN layer itself has a golden color tone and can be used, for example, as an indicative layer to determine the state of use of the coated tool by a change in the surface color tone (the TiN may have a non-stoichiometric composition as long as it develops a golden color).

The TiN layer as the indicative layer should preferably have an average thickness in the range of 0.1 to 1.0 µm. A thickness of less than 0.1 µm leads to generation of interference fringes that hinders observation of a change in color tone of the indicative layer. A thickness exceeding 1.0 µm leads to chipping of the TiN layer.

### (5) Other layer

In this embodiment, the deposition process is designed so as not to form any layer other than the A, B, and C layers. However, unintended fluctuations in pressure and temperature in the deposition system may occur during switching of the layer to be deposited (switching of a layer to the adjacent layer). As a result, a layer containing oxygen and carbon and thus differing in composition from adjacent layers may be unintendedly formed between the adjacent layers.

### (6) Determination of thickness of coating layer

The surface of the substrate of a cBN sintered compact is observed as follows: A longitudinal section is prepared and is subjected to elemental mapping by energy dispersive X-ray spectroscopy (EDS) (for example at a beam diameter of 20 nm) to determine the interface between the substrate and the A layer. The average straight line is arithmetically calculated from the roughness curve of the interface and is defined as the surface of the substrate.

The average straight line m, which crosses the roughness curve, extends over at least 15 µm (at least 15 µm in the direction parallel to the surface of the cBN sintered compact treated as flat for defining the longitudinal section) and divide the roughness curve into an upper half portion and a lower half portion by line m, such that the upper half portion equals in area the lower half portion. In drawing the straight line m, areas that are less than 10% of the maximum height (highest peak) and of the maximum depth (deepest valley) of the roughness curve were treated as noise and were not included in the area comparison.

Peak and valley values perpendicular to the average line are measured. The sum of the absolute average of the highest peak value to the fifth value and the absolute average of the lowest valley value to the fifth value is defined as the surface roughness R.

After the surface of the substrate is determined, the average thickness of each of the A, B, C, and TiN layers (the TiN layer is provided as necessary) and the average thickness of the coating layer are measured with the surface of the substrate as a reference. For each layer, three or more vertical lines are drawn from the average straight line at different positions to determine the thicknesses of each layer and the thicknesses are averaged to give an average thickness.

The average composition of each of the A, B, and C layers is determined by cross-sectional measurement with a SEM, a transmission electron microscope (TEM), and energy dispersive X-ray analysis (EDS) (an example beam diameter is 20 nm), and the observed values are averaged.

### 3. Production

A typical method of manufacturing the coated tool in accordance with the embodiment is as follows:

### (1) cBN sintered compact

The cBN sintered compact may be produced by any known process. For example, cBN grains is prepared as raw material powder for forming a hard phase, and TiN, TiCN, Al, AlN, and Al₂O₃ powders are prepared as raw material powders for forming a binder phase. These are blended such that the cBN grains content is 40 to 70 vol%, wet-mixed, dried, and compacted under pressure. The compact is held at a predetermined temperature under a vacuum atmosphere for temporary sintering, then charged into an ultrahigh pressure sintering apparatus, and sintered at a predetermined temperature.

### (2) Coating layer

The coating layer is produced, for example through an arc ion plating (AIP) method using alloy targets having compositions of the A, B, C, and TiN layers (TiN layer is provided if necessary) while deposition parameters, such as the arc voltage, reaction gas pressure, and bias voltage are being adjusted.

### Examples

The present invention will now be described by way of examples, which however should not be construed to limit to the present invention.

### 1. Preparation of cBN sintered compact

cBN grains with an average particle size of 2.5 to 6.0 µm as a raw material powder was prepared for forming a hard phase, and TiN, TiC, TiCN, Al, AlN, and Al₂O₃ powders were prepared for forming a binder phase. These are compounded in accordance with formulations shown in Table 1. The powders contained trace amounts of unavoidable impurities.

Each raw material powder mixture was wet-mixed in a ball mill for 72 hours, dried, and pressed into a compact of 50 mm in diameter by 1.5 mm in thickness under a pressure of 100 MPa. The green compact was preliminarily sintered at a specified temperature below 1000°C under vacuum atmosphere of less than 1Pa. The pre-compact was then loaded into an ultrahigh-pressure sintering system and sintered at a specified temperature below 1300°C under a pressure of 5 GPa to produce a cBN sintered compact.

**[Table 1]**

| Substrate No. | Composition (vol%) | | | | | |
|---|---|---|---|---|---|---|
| | TiN | TiCN | Al | AlN | Al₂O₃ | cBN |
| 1 | 0 | 24 | 32 | 0 | 4 | 40 |
| 2 | 32 | 0 | 16 | 0 | 2 | 50 |
| 3 | 18 | 0 | 11 | 1 | 0 | 70 |

The sintered compact was cut into specified dimensions with a wire electrical discharge machine, and brazed to a braze portion (corner) of a WC cemented carbide insert body with a composition of Co: 5% by mass, TaC: 5% by mass, and WC: the balance, using Ag-based brazing material ( Cu: 26 mass%, Ti: 5 mass%, Ag: the balance), and then the top, bottom, and outer surfaces were polished and honed to produce cBN Substrates 1 to 3 with an insert shape in accordance with ISO standard CNGA120408.

### 2. Deposition of coating layer

Coating layers were formed on Substrates 1 to 3 by the following processes (1) to (5) in an arc ion plating system. Targets having alloy compositions corresponding to the compositions of the A, B, C, and TiN layers to be deposited were placed in the arc ion plating system.
(1) Each of Substrates 1 to 3 were ultrasonically cleaned in acetone, dried, and mounted along the periphery at a predetermined distance in the radial direction from the central axis on a turn table in an arc ion plating system.
(2) The arc ion plating system was evacuated to be maintained under a vacuum of 10⁻² Pa or less, while the system was being heated to 500°C with a heater and then purged with an Ar gas atmosphere of 2.0 Pa. While A DC bias voltage of -300 V was applied to a spinning substrate on the turn table, the surface of the substrate was subjected to bombardment with argon ions for 30 minutes. In this case, the bombardment conditions were controlled to yield a prescribed R.
(3) The A layer was deposited as follows:
   Nitrogen reactive gas was introduced into the arc ion plating system to create a predetermined reaction atmosphere of 4.0 to 8.0 Pa as shown in Table 2, and the temperature in the system was maintained at a temperature also shown in Table 2. A predetermined DC bias voltage of -30 to -60 V as shown in Table 2 was applied to the substrate, and a predetermined current of 120 to 160 A as shown in Table 2 was simultaneously applied between a cathode (evaporation source) and an anode being an Al-Ti alloy target with a specified composition for a given time to generate an arc discharge. An A layer composed of (Al,Ti)N with a composition and an average thicknesses shown in Table 4 was thereby formed by vapor deposition on the surface of the substrate.
(4) The B layer was deposited as follows:
   Nitrogen reactive gas was introduced into the arc ion plating system to create a specified reaction atmosphere within the range of 5.0 to 8.0 Pa as shown in Table 2, maintained at a temperature in the system as also shown in Table 2. A predetermined DC bias voltage within the range of -30 to -60 V as shown in Table 2 was applied to the substrate, and a specified electric current in the range of 120 to 180 A as shown in Table 2 was applied between the cathode (evaporation source) and anode being an Al-Ti-Si alloy target of a specified composition to generate an arc discharge. A B layer with a composition and an average thickness shown in Table 4 was thereby formed on the surface of the A layer.
(5) The C layer was deposited as follows:
   Nitrogen reactive gas was introduced into the arc ion plating system to create a specified reaction atmosphere within the range of 4.0 to 7.0 Pa as shown in Table 2, maintained at a temperature in the system as also shown in Table 2. A predetermined DC bias voltage within the range of -30 to -70 V as shown in Table 2 was applied to the substrate, and a specified electric current within the range of 100 to 180A as shown in Table 2 was applied between a cathode (evaporation source) and an anode being an Al-Cr-Si-Cu alloy target of a specified composition to generate an arc discharge. A C layer with a composition and an average thickness shown in Table 4 was thereby deposited on the surface of the B layer.

Inventive coated tools (Examples) 1 to 10 were made through these procedures.

Comparative coated tools (Comparative Examples) 1 to 6 shown in Table 5 were also fabricated using cBN substrates 1 to 3, respectively, with proviso that the conditions in procedures (3) to (5) were changed as shown in Table 3.

In each of Examples 2, 3, 5, 6, 8 and 9 and Comparative Examples 4 and 6, a cathode (evaporation source) made of metallic Ti was installed in an arc ion plating system, and a TiN layer with a thickness of 0.1 to 1.0 µm was further deposited on the coating layer under the following deposition conditions.

For deposition of the TiN layer, nitrogen reactive gas was introduced into the arc ion plating system to create a reaction atmosphere of 5.0 Pa, and the system was maintained at a temperature shown in Table 2 and 3 for each of the examples and comparative examples. A DC bias voltage of -40 V was applied to the substrate and a predetermined current of 120 A was simultaneously applied between the cathode (evaporation source) and the anode for a predetermined time to generate an arc discharge to form the TiN layer.

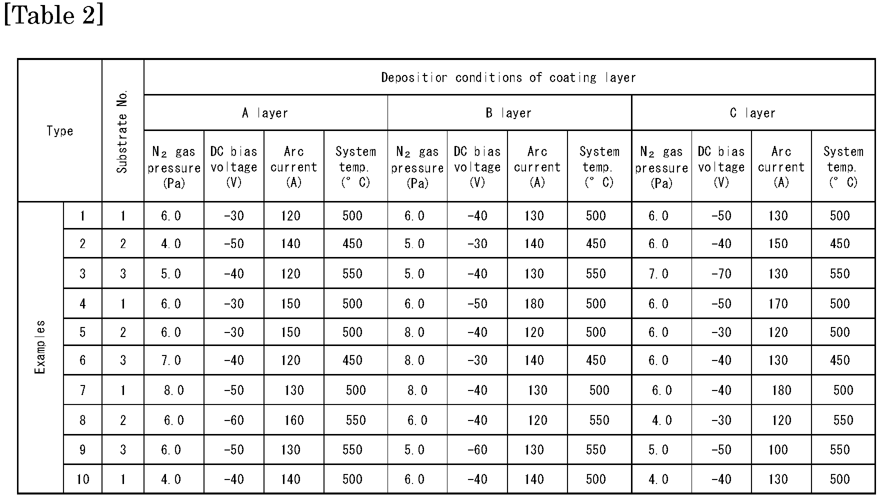

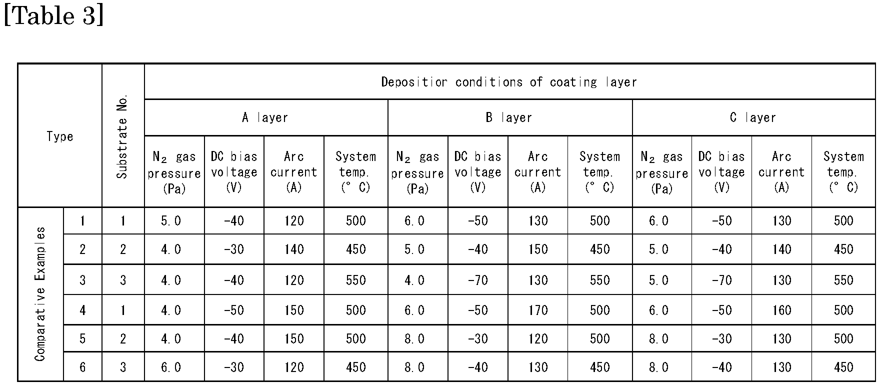

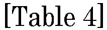

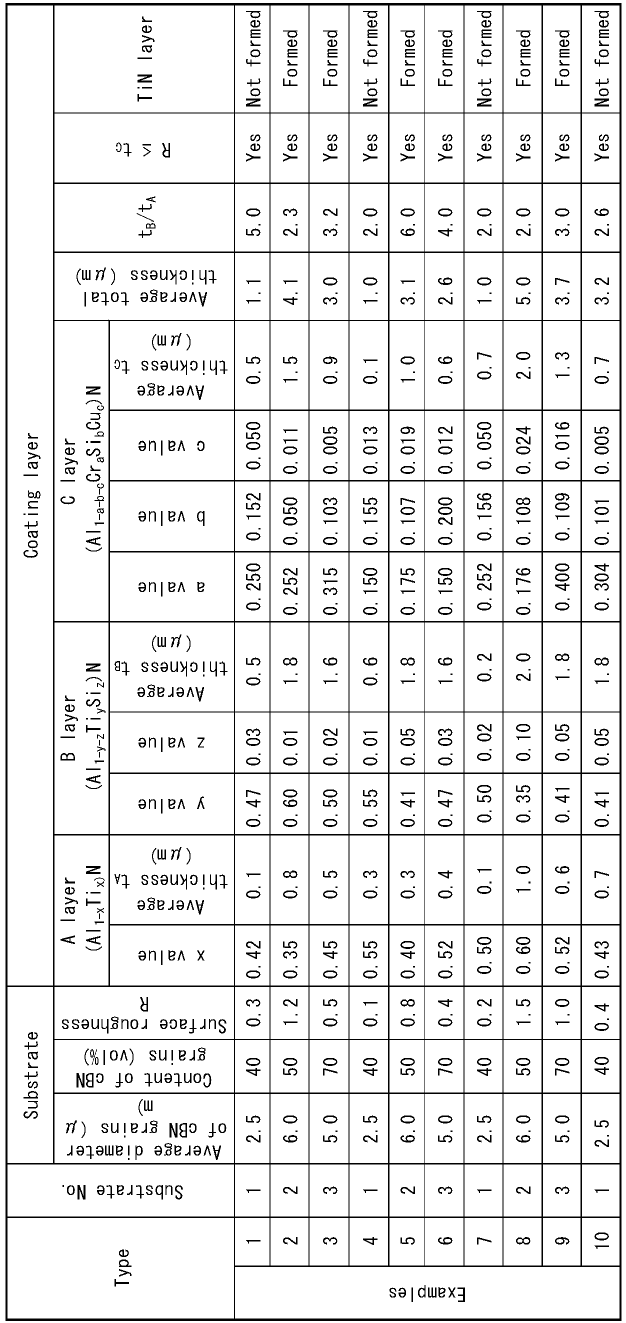

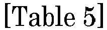

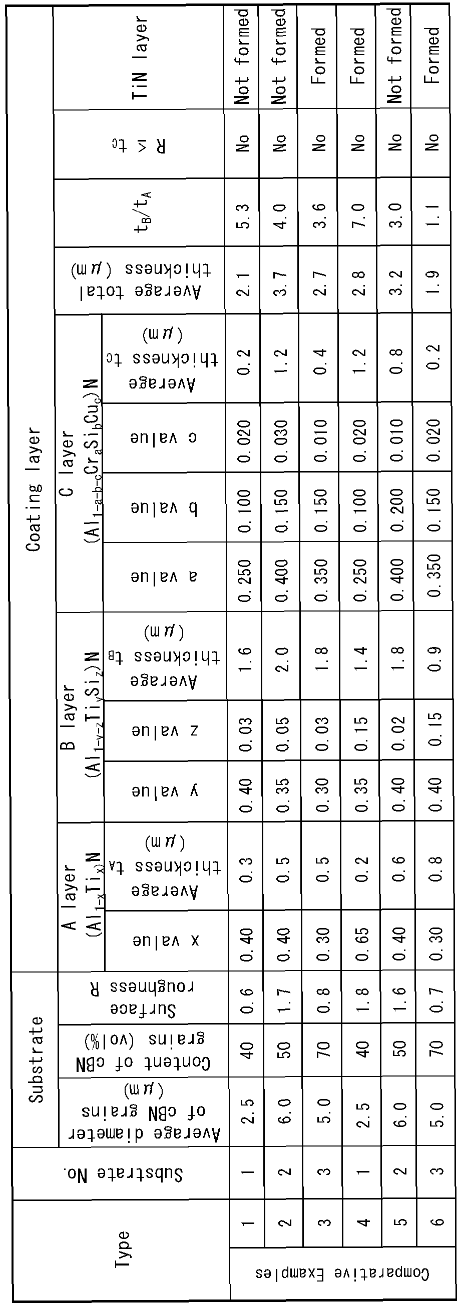

The coated tools of Examples 1 to 10 and Comparative Examples 1 to 6 were subjected to the following cutting tests.

### Cutting Test

- Workpiece: Round bar of carburized and hardened JIS SCr420 (HRC60)
- Cutting speed: 200 m/min
- Depth of cut: 0.1 mm
- Feed: 0.15 mm

The sample was cut into a cut length of 1000 m, and the amount of wear on the flank surface was measured.

Table 6 shows the results.

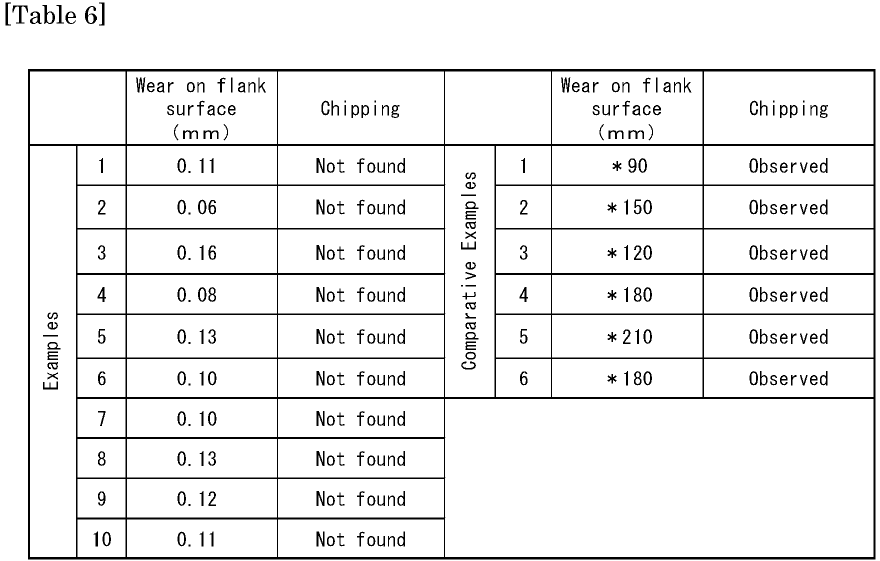

In Table 6, "*" indicates the time (sec) from the start of cutting to the end of life because chipping indicating the life of the tool occurred before the scheduled cut length of the cutting.

The results in Table 6 demonstrate that tools of Examples 1 to 10 can be used for cutting without chipping and thus have high wear resistance. In contrast, tools of Comparative Examples 1 to 6 reached the end of their service life within a short time due to the occurrence of chipping or progression of wear on the flank surface.

The foregoing disclosed embodiments are in all respects exemplary and not restrictive; the scope of the present invention is indicated by the claims, not by the embodiments, and is intended to include all variations within the meaning and scope of the claims.

### Citation List

1 substrate (cBN sintered compact)
2 A layer (AlTiN layer)
3 B layer (AlTiSiN layer)
4 C layer (AlCrSiCuN layer)
5 TiN layer
6 cBN grains
7 binder phase

## Claims

1. A surface-coated cutting tool comprising a substrate and a coating layer provided on the substrate;
the substrate comprising a sintered compact containing cubic boron nitride grains in an amount of 40 vol% or more and 70 vol% or less, the substrate having a surface roughness R of 0.1 µm or more and 1.5 µm or less, the cubic boron nitride grains having a mean grain size of 2.5 µm or more and 6.0 µm or less;
the coating layer having an average thickness of 1.0 µm or more and 5.0 µm or less, the coating layer including an A layer, a B layer, and a C layer from the surface of the substrate toward the surface of the tool;
the A layer having an average composition represented by the formula: (Al₁₋ₓTiₓ)N (where 0.35 ≤ x ≤ 0.60) and an average thickness t_{A} of 0.1 µm or more and 1.0 µm or less;
the B layer having an average composition represented by the formula: (Al_{1-y-z}Ti_{y}Si_{z})N (where 0.35 ≤ y ≤ 0.60 and 0.01 ≤ z ≤ 0.10) and an average thickness t_{B} of 0.2 µm or more and 2.0 µm or less;
the C layer having an average composition represented by the formula (Al_{1-a-b-c}CrₐSi_{b}Cu_{c})N (where 0.150 ≤ a ≤ 0.400, 0.050 ≤ b ≤ 0.200 and 0.005 ≤ c ≤ 0.050) and an average thickness t_{C} of 0.1 µm or more and 2.0 µm or less; and
the ratio t_{B}/t_{A} being 2.0 or more and 6.0 or less, and R ≤ t_{C}.

2. The surface-coated cutting tool as claimed in claim 1, further comprising a TiN layer on the C layer.

## Patentansprüche

1. Oberflächenbeschichtetes Schneidwerkzeug, umfassend ein Substrat und eine auf dem Substrat vorgesehene Beschichtungsschicht;
wobei das Substrat einen Sinterkörper umfasst, der kubische Bornitridkörner in einer Menge von 40 Vol.-% oder mehr und 70 Vol.-% oder weniger enthält, wobei das Substrat eine Oberflächenrauheit R von 0,1 µm oder mehr und 1,5 µm oder weniger aufweist, wobei die kubischen Bornitridkörner eine mittlere Korngröße von 2,5 µm oder mehr und 6,0 µm oder weniger aufweisen;
wobei die Beschichtungsschicht eine durchschnittliche Dicke von 1,0 µm oder mehr und 5,0 µm oder weniger aufweist, wobei die Beschichtungsschicht eine A-Schicht, eine B-Schicht und eine C-Schicht von der Oberfläche des Substrats zur Oberfläche des Werkzeugs hin umfasst;
wobei die A-Schicht eine durchschnittliche Zusammensetzung aufweist, die durch die Formel (Al₁₋ₓ Tiₓ)N (wobei 0,35 ≤ x ≤ 0,60) dargestellt wird, und eine durchschnittliche Dicke t_{A} von 0,1 µm oder mehr und 1,0 µm oder weniger aufweist;
wobei die B-Schicht eine durchschnittliche Zusammensetzung aufweist, die durch die Formel (Al_{1-y-z} Ti_{y} Si_{z} N (wobei 0,35 ≤ y ≤ 0,60 und 0,01 ≤ z ≤ 0,10) dargestellt wird, und eine durchschnittliche Dicke t_{B} von 0,2 µm oder mehr und 2,0 µm oder weniger aufweist;
wobei die C-Schicht eine durchschnittliche Zusammensetzung aufweist, die durch die Formel (Al_{1-a-b-c}Crₐ Si_{b}Cu_{c} N (wobei 0,150 ≤ a ≤ 0,400, 0,050 ≤ b ≤ 0,200 und 0,005 ≤ c ≤ 0,050) dargestellt wird, und eine durchschnittlichen Dicke t_{C} von 0,1 µm oder mehr und 2,0 µm oder weniger aufweist; und
wobei das Verhältnis t_{B}/t_{A} 2,0 oder mehr und 6,0 oder weniger beträgt und R ≤ t_{C} ist.

2. Oberflächenbeschichtetes Schneidwerkzeug nach Anspruch 1, das ferner eine TiN-Schicht auf der C-Schicht umfasst.

## Revendications

1. Outil de coupe à revêtement de surface comprenant un substrat et une couche de revêtement prévue sur le substrat;
le substrat comprenant un compact fritté contenant des grains de nitrure de bore cubique en une quantité de 40 % en volume ou plus et de 70 % en volume ou moins, le substrat ayant une rugosité de surface R de 0,1 µm ou plus et de 1,5 µm ou moins, les grains de nitrure de bore cubique ayant une taille moyenne de grain de 2,5 µm ou plus et de 6,0 µm ou moins;
la couche de revêtement ayant une épaisseur moyenne de 1,0 µm ou plus et de 5,0 µm ou moins, la couche de revêtement comprenant une couche A, une couche B et une couche C depuis la surface du substrat vers la surface de l'outil;
la couche A ayant une composition moyenne représentée par la formule: (Al₁₋ₓ Tiₓ)N (où 0,35 ≤ x ≤ 0,60) et une épaisseur moyenne t_{A} de 0,1 µm ou plus et 1,0 µm ou moins;
la couche B ayant une composition moyenne représentée par la formule: (Al_{1-y-z} Ti_{y} Si_{z})N (où 0,35 ≤ y ≤ 0,60 et 0,01 ≤ z ≤ 0,10) et une épaisseur moyenne t_{B} de 0,2 µm ou plus et de 2,0 µm ou moins;
la couche C ayant une composition moyenne représentée par la formule (Al_{1-a-b-c}Crₐ Si_{b} Cu_{c})N (où 0,150 ≤ a ≤ 0,400, 0,050 ≤ b ≤ 0,200 et 0,005 ≤ c ≤ 0,050) et une épaisseur moyenne t_{C} de 0,1 µm ou plus et de 2,0 µm ou moins; et
le rapport t_{B} /t_{A} étant compris entre 2,0 et 6,0, et R ≤ t_{C}.

2. Outil de coupe à revêtement de surface selon la revendication 1, comprenant en outre une couche de TiN sur la couche C.
